# EUROPÄISCHE PATENTSCHRIFT

(11) **EP 0 523 594 B1**
(45) Veröffentlichungstag und Bekanntmachung des Hinweises auf die Patenterteilung: **18.11.1998**
(21) Anmeldenummer: 92111912.9
(22) Anmeldetag: 13.07.1992
(51) Int. Cl.: G01R 31/305, G01R 31/302, G01R 31/308

(54) **Verfahren zur Korpuskularstrahl-Prüfung von Substraten für Flüssigkeitskristallanzeigen (LCD)**
Method for testing substrater for liquid crystal displays (LCD) using a corpuscular beam
Procédé pour tester des substrats pour dispositifs d'affichage à cristal liquide utilisant un faisceau corpusculaire

(30) Priorität: 15.07.1991 DE 4123415
(43) Veröffentlichungstag der Anmeldung: 20.01.1993
(73) Patentinhaber: ETEC EBT GmbH, 85551 Heimstetten (DE)
(72) Erfinder: Brunner, Matthias, Dr., W-8011 Kirchheim (DE); Schmitt, Reinhold, Dipl.-Ing., W-8000 München 83 (DE)
(74) Vertreter: Tetzner, Volkmar, Dr.-Ing. Dr. jur.

(56) Entgegenhaltungen:
- EP-A- 0 129 508
- EP-A- 0 189 777
- EP-A- 0 290 066
- US-A- 4 621 260
- PATENT ABSTRACTS OF JAPAN vol. 11, no. 345 (P-636)12. November 1987 & JP-A-62 127 675 ( CITIZEN WATCH ) 9. Juni 1987
- PATENT ABSTRACTS OF JAPAN vol. 8, no. 92 (P-271)(1529) 27. April 1984; & JP-A-59 007 270 ( TOKYO SHIBAURA )
- IBM TECHNICAL DISCLOSURE BULLETIN. Bd. 15, Nr. 8, Januar 1973, NEW YORK US Seiten 2547 - 2548 J.J. DESTAFENO ET AL. 'DISPLAY OF VOLTAGE DISTRIBUTION ON MICROCIRCUITS'

## Beschreibung

Die Erfindung bezieht sich auf Verfahren zur Prüfung eines Substrats für eine Flüssigkristallanzeige, die eine Vielzahl von Bildelementen besitzt, wobei das Substrat aus einem lichtdurchlässigen Isolatorkörper besteht und auf dessen Oberfläche eine Vielzahl von Flächenelektroden, Schaltelementen und Steuerleitungen so aufgebracht sind, daß jeweils eine Flächenelektrode über ein Schaltelement mit Steuerleitungen verbunden ist.

Ein Verfahren zum berührungslosen Testen von Leitungsnetzwerken auf Kurzschlüsse und Unterbrechungen ist aus der europäischen Patentschrift EP 0 189 777 B1 bekannt.

Aus der EP-A-0 290 066 ist ein Testverfahren für Flüssigkristallanzeigen bekannt, bei dem die Bildelektroden mittels eines Elektronenstrahls gescannt werden, um die mit den Bildelektroden verbundenen Schaltelemente zu testen.

Die JP-A-59 72 70 beschreibt ein Verfahren zur Potentialmessung mittels eines Elektronenstrahls.

Die JP-A-62 127 675 offenbart ein Testverfahren für Bildelemente, bei dem eine Meßspannung angelegt wird, während das Substrat von einem Elektronenstrahl abgetastet wird, wodurch ein Strom durch ein Bildelement erzeugt wird, der gemessen und verarbeitet wird.

Der Erfindung liegt die Aufgabe zugrunde, ein Verfahren zur Korpuskularstrahl-Prüfung von Substraten für Flüssigkristallanzeigen anzugeben, daß umfassendere Meßergebnisse liefert. Diese Aufgabe wird erfindungsgemäß durch die Ansprüche 1 und 4 gelöst.

Weitere Merkmale sind Gegenstand der Unteransprüche.

Erfolgt die Messung erst nach einer definierten Wartezeit, so können vor allem Fehler im Zeitverhalten eines Bildelements festgestellt werden.

Der mit der Erfindung erzielbare Vorteil liegt insbesondere auch darin, daß defekte Substrate repariert oder bereits vor einer Weiterverarbeitung ausgesondert und damit Kosten gespart werden können.

Die Erfindung wird nachfolgend anhand der Zeichnung näher erläutert. Dabei zeigt
- Figur 1: eine Schnittdarstellung einer Flüssigkristallanzeige, die aus zwei Substraten und einem dazwischenliegenden Flüssigkristall besteht,
- Figur 2: ein zu prüfendes Substrat auf das Teile von Bildelementen aufgebracht sind,
- Figur 3: ein elektrisches Ersatzschaltbild eines Bildelementes.

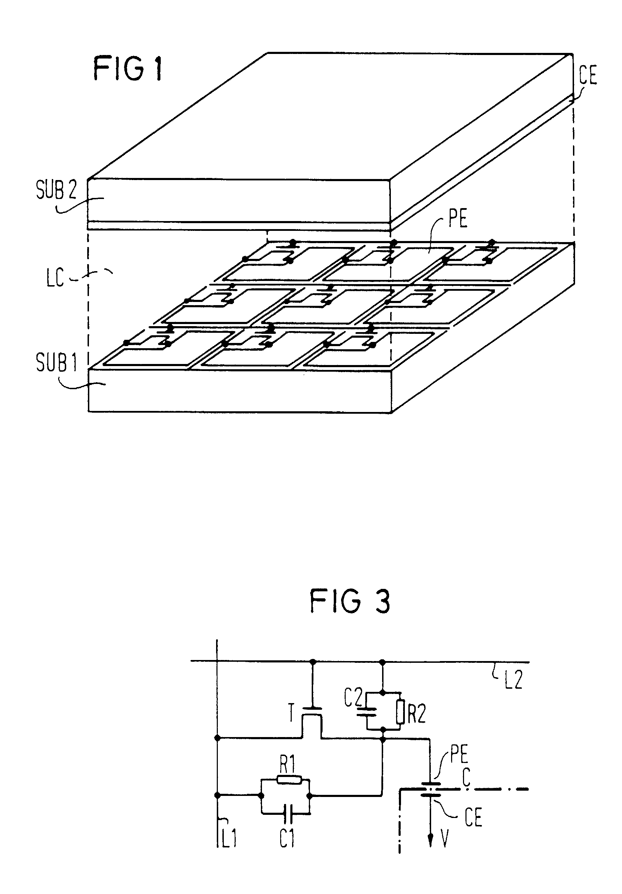

Wie aus Figur 1 ersichtlich, bestehen Flüssigkristallanzeigen (LCD) im wesentlichen aus zwei Substraten SUB1 und SUB2, zwischen denen ein Flüssigkristall LC eingeschlossen ist. Auf dem Substrat SUB1 im dargestellten Fall ist eine Vielzahl von Flächenelektroden und auf dem Substrat SUB2 ist eine ergänzende Flächenelektrode CE aufgebracht. Die Flächenelektrode PE bildet beispielsweise mit der ergänzenden Flächenelektrode CE des gegenüberliegenden Substrats einen Kondensator in dessen Feld langkettige Flüssigkristallmoleküle ausgerichtet werden, wodurch der Flüssigkristall im Bereich der Flächenelektrode PE lichtdurchlässig wird. Will man nun das Substrat SUB1 getrennt vom Substrat SUB2 testen, so stößt der bestimmungsgemäße Betrieb auf Schwierigkeiten, da die durch die Flächenelektroden, den Flüssigkristall und die ergänzende Flächenelektrode CE gebildeten Kapazitäten nicht vorhanden sind.

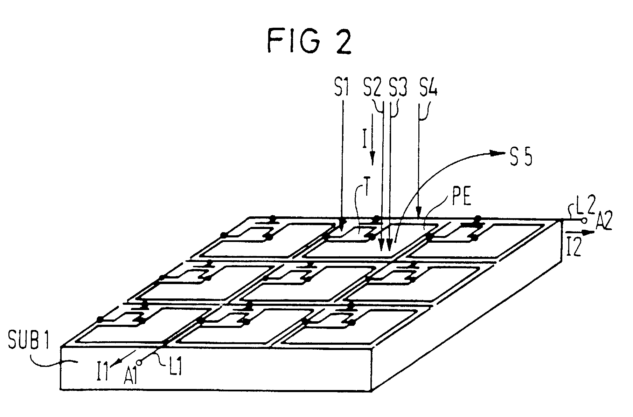

In Figur 2 ist nur das Substrat SUB1 mit einer Vielzahl von Flächenelektroden, Schaltelementen in Form von MOS-Transistoren und Steuerleitungen gezeigt, wobei Gateanschlüsse von MOS-Transistoren einer Zeile mit einer Steuerleitung, Sourceanschlüsse der MOS-Transistoren einer Spalte mit einer Steuerleitung und die jeweiligen Flächenelektroden der Bildelemente mit den Drainanschlüssen der MOS-Transistoren matrixartig verbunden sind. Beispielhaft ist die Flächenelektrode PE eines Bildelementes mit dem Drainanschluß eines MOS-Transistors T verbunden, dessen Gateanschluß mit einer Steuerleitung L2 und dessen Sourceanschluß mit einer Steuerleitung L1 kontaktiert ist. Die Leitung L1 besitzt einen Leitungsanschluß A1 und die Leitung L2 besitzt einen Leitungsanschluß A2. Ein Strom der Leitung L1 ist mit I1 und ein Strom der Leitung L2 ist mit 12 bezeichnet. Auf die Leitung L1 ist ein Korpuskularstrahl S1 und auf die Leitung L2 ist ein Korpuskularstrahl S4 gerichtet. Auf die Flächenelektrode PE selbst ist ein Korpuskularstrahl S2 gerichtet um einen Strom I der Flächenelektrode PE zuzuführen. Getrennt zum Korpuskularstrahl S2 ist ein Korpuskularstrahl S3 auf die Flächenelektrode PE gerichtet, der Sekundärelektronen S5 bewirkt. Die getrennten Korpuskularstrahlen 52 und 53 deuten hierbei an, daß zur Einstellung eines Potentials oder eines definierten Stromes I in seinen Eigenschaften nicht identisch zu sein braucht mit dem Korpuskularstrahl S3, der zur Auslösung von Sekundärelektronen dient. So ist zum Beispiel denkbar, daß durch den Korpuskularstrahl S2 der Flächenelektrode PE ein größerer Strom I zugeführt wird als durch den Korpuskularstrahl S3, der zur Messung dient, oder daß der Korpuskularstrahl 52 aus einem Elektronenstrahl und der Korpuskularstrahl S3 aus einem Laserstrahl besteht, der Sekundärelektronen 55 in Form von Photoelektronen erzeugt.

Figur 3 zeigt ein elektrisches Ersatzschaltbild eines Bildelementes mit einem MOS-Transistor T als Schaltelement, dessen Sourceanschluß mit der Steuerleitung L1 und dessen Gateanschluß mit der Steuerleitung L2 kontaktiert ist. Ein Drainanschluß des MOS-Transistors T ist mit der Flächenelektrode PE verbunden, die zusammen mit der gemeinsamen Flächenelektrode PE eine Kapazität C des Bildelementes bildet, wobei die ergänzende Flächenelektrode CE mit einem Versorgungsspannungsanschluß V verbunden ist. Durch eine Schnittlinie, die die beiden Flachen elektroden PE und CE voneinander trennt ist die Schaltungsaufteilung auf zwei Substrate angedeutet. Ferner sind die wesentlichen parasitären Schaltelemente in Form eines Widerstandes R1 und einer dazu parallel geschalteten Kapazität C1 zwischen dem Drainanschluß des MOS-Transistors T und der Steuerleitung L1 sowie einer Parallelschaltung aus einem Widerstand R2 und einer Kapazität C2 zwischen dem Drainanschluß des MOS-Transistors T und der Steuerleitung L2 dargestellt.

Als Schaltelemente werden neben den beschriebenen MOS-Transistoren häufig auch Dioden oder sogenannte MIM-Elemente (Metall-Isolator-Metall) verwendet, wobei beispielsweise jeweils zwischen einer Steuerleitung und der Flächenelektrode eines Bildelementes eine Diode vorgesehen ist oder zwischen der Flächenelektrode und einer Steuerleitung ein MIM-Element eingefügt ist. Auch die Aufteilung der Schaltelemente und der Flächenelektroden auf den beiden Substraten SUB1 und SUB2 kann unterschiedlich ausgeführt sein und ist nur beispielhaft beschrieben.

Bei einem ersten erfindungsgemäßen Ausführungsbeispiel werden bei jedem Bildelement innerhalb eines Einstellzeitintervalls Steuerleitungen L1 und L2, die über den MOS-Transistor T mit der Flächenelektrode PE verbunden sind, auf ein definiertes Potential gebracht, wobei dies beispielsweise über den Leitungsanschluß A1 bzw. A2 oder über den Korpuskularstrahl S1 bzw. 54 erfolgen kann. Aufgrund der in Figur 3 dargestellten parasitären Elemente R1, C1, R2 und C2 und den MOS-Transistor T stellt sich auf der Flächenelektrode PE ein entsprechendes Potential ein. Zur Messung des Potentials der Flächenelektrode PE wird bei diesem Verfahren ein Korpuskularstrahl S3, innerhalb eines Meßzeitintervalls, auf die Flächenelektrode PE gerichtet und die dabei ausgelösten Sekundärelektronen S5 bestimmt. Die Anzahl der Sekundärelektronen die in einen Detektor fallen hängt dabei vom Potential der Flächenelektrode PE ab, da die Anziehungs- bzw. Abstoßungskräfte vom Potential der Flächenelektrode PE abhängen. Bei defekten Bildelementen entstehen Abweichungen vom jeweiligen Soll-Potential, die beispielsweise durch einen elektronischen Rechner leicht auswertbar sind. Werden Leitungen mit Hilfe eines Korpuskularstrahls aufgeladen, so muß dies zyklisch wiederholt werden, da sich die Leitungen allmählich wieder entladen. Das Einstellzeitintervall ist dabei so zu wählen, daß die Potentiale auf den Steuerleitungen nur innerhalb einer bestimmten Meßtoleranz ihr Potential ändern. Das Meßzeitintervall muß dabei möglichst kurz sein, damit keine nennenswerte Potentialänderung auf der Flächenelektrode PE auftritt.

Ein zweites erfindungsgemäßes Ausführungsbeispiel zur Korpuskularstrahl-Prüfung eines Substrats für eine Flüssigkeitskristallanzeige besteht darin, daß der definierte Strom I der Flächenelektrode PE mit Hilfe des Korpuskularstrahls S2 zugeführt wird und mit Hilfe das Korpuskularstrahls S3, der ebenfalls auf die Flächenelektrode PE gerichtet ist, die Sekundärelektronen S5 ausgelöst werden und damit das Potential der Flächenelektrode PE gemessen wird. In vielen Fällen wird der Korpuskularstrahl S2 mit dem Korpuskularstrahl S3 identisch sein, da der Korpuskularstrahl für die Zuführung des Stromes I auch zur Auslösung von Sekundärelektronen geeignet ist. Durch die in Figur 3 angedeuteten parasitären Elemente R1, C1, R2 und C2 und durch das Schaltelement T wird der Strom I abgeleitet, so daß sich ein bestimmtes Potential auf der Flächenelektrode PE einstellt. Dieses sich einstellende Potential kann jeweils mit einem Soll-Potential verglichen und daraus ein Testergebnis für ein Bildelement gebildet werden.

Bei einem dritten erfindungsgemäßen Ausführungsbeispiel zur Korpuskularstrahl-Prüfung eines Substrats für eine Flüssigkeitskristallanzeige wird ebenfalls ein definierter Strom I der Flächenelektrode PE zugeführt. Hier wird jedoch nicht das Potential der Flächenelektrode, sondern die Ströme I1 und I2, die sich aufgrund der parasitären Elemente R1, C1, R2 und C2 und den MOS-Transistor T einstellen, gemessen. Die Messung der Ströme I1 und I2 erfolgt über die Leitungsanschlüsse A1 und A2, die mit externen Meßkontakten verbunden sind.

Bei allen drei Ausführungsbeispielen erfolgt die Messung erst nach einer derart definierten Wartezeit, daß Fehler im Zeitverhalten eines Bildelementes festgestellt werden können. Wenn die Messung erst nach dem Einstellzeitintervall erfolgt, ist es möglich verschiedene Schaltzustände des Schaltelements über die mit ihm verbundenen Steuerleitungen während eines Meßzeitintervalls einzustellen. Die Steuerleitungen können dabei über die Anschlüsse A1 bzw. A2 oder über den Korpuskularstrahl S1 bzw. S4 eingestellt werden.

Die drei Ausführungsbeispiele können auch kombiniert werden, wobei beispielsweise über einen Anschluß A2 ein definiertes Potential auf der Leitung L2 erzeugt wird, über einen Korpuskularstrahl S2 ein definierter Strom I der Flächenelektrode PE zugeführt wird, der Strom I1 der Leitung L1 über einen Anschluß A1 gemessen wird und das Potential der Flächenelektrode PE über die durch den Korpuskularstrahl S2 ausgelösten Sekundärelektronen S5 detektiert werden.

Als Korpuskularstrahl ist vor allem ein Elektronenstrahl geeignet. Es kann sich aber auch um einen Photonenstrahl eines Lasers, der Sekundärelektronen in Form von Photoelektronen erzeugt, handeln. Häufig wird auch zur Reparatur sehr feiner Leiterbahnstrukturen ein Ionenstrahl benutzt, der ebenfalls Sekundärelektronen auslöst. Durch den Einsatz eines Ionenstrahls für die obengenannten Aufgaben läßt sich daher ein erfindungsgemäßes Prüfungsverfahren mit einer Reparatur verbinden.

## Patentansprüche

1. Verfahren zur Korpuskularstrahl-Prüfung, bei dem ein Substrat für eine Flüssigkristallanzeige geprüft wird,
die eine Vielzahl von Bildelementen besitzt, wobei das Substrat (SUB1) aus einem lichtdurchlässigen Isolatorkörper besteht, auf dessen Oberfläche eine Vielzahl von Flächenelektroden (PE), Steuerleitungen (L1, L2) und Schaltelementen mit parasitären Elementen (R1, C1, R2, C2) so aufgebracht sind, daß jeweils eine Flächenelektrode über mindestens ein Schaltelement (T) mit Steuerleitungen (L1, L2) verbunden ist,
bei dem jeweils innerhalb eines Einstellzeitintervalls die Steuerleitungen (L1, L2) auf ein vorgegebenes Potential gebracht werden oder der Flächenelektrode (PE) mit Hilfe eines Korpuskularstrahls (S2) ein definierter Strom zugeführt wird,
und innerhalb eines Meßzeitintervalls, das sich an der Flächenelektrode (PE) einstellende Potential durch Bestimmung der durch einen Korpuskularstrahl (S3) ausgelösten Sekundärelektronen (S5) gemessen und mit einem jeweiligen Soll-Potential verglichen und daraus ein Testergebnis von einem Bildelement gebildet wird,
wobei zwischen dem Ende des Einstellzeitintervalls und dem Beginn des Meßzeitintervalls eine derart definierte Wartezeit eingehalten wird, daß Fehler im Zeitverhalten eines Bildelements feststellbar sind.

2. Verfahren nach Anspruch 1, dadurch gekennzeichnet, daß die Steuerleitungen (L1, L2), die über ein Schaltelement (T) mit einer Flächenelektrode (PE) verbunden sind, über ihre Leitungsanschlüsse (A1, A2) auf ein jeweils vorgegebenes Potential gebracht werden.

3. Verfahren nach Anspruch 1, dadurch gekennzeichnet, daß die Steuerleitungen (L1, L2), die über ein Schaltelement (T) mit einer Flächenelektrode (PE) verbunden sind, durch einen Korpuskularstrahl (S1, S4) auf ein jeweils vorgegebenes Potential gebracht werden.

4. Verfahren zur Korpuskularstrahl-Prüfung, bei dem ein Substrat für eine Flüssigkristallanzeige geprüft wird,
die eine Vielzahl von Bildelementen besitzt, wobei das Substrat (SUB1) aus einem lichtdurchlässigen Isolatorkörper besteht, auf dessen Oberfläche eine Vielzahl von Flächenelektroden (PE), Steuerleitungen (L1, L2) und Schaltelementen mit parasitären Elementen (R1, C1, R2, C2) so aufgebracht sind, daß jeweils eine Flächenelektrode über mindestens ein Schaltelement (T) mit Steuerleitungen (L1, L2) verbunden ist,
bei dem jeweils innerhalb eines Einstellzeitintervalls der Flächenelektrode (PE) mit Hilfe eines Korpuskularstrahls (S2) ein definierter Strom (I) zugeführt wird,
und innerhalb eines Meßzeitintervalls ein Strom (I1, I2) einer Steuereinleitung (L1, L2), die über ein Schaltelement (T) mit einer Flächenelektrode (PE) verbunden ist, gemessen wird, wobei die Strommessung über einen Leitungsanschluß (A1, A2) der Steuerleitung (L1, L2) erfolgt, und bei dem jeweils der gemessene Strom (I1, I2) mit einem jeweiligen Soll-Strom verglichen und daraus ein Testergebnis für ein Bildelement gebildet wird,
wobei zwischen dem Ende des Einstellzeitintervalls und dem Beginn des Meßzeitintervalls eine derart definierte Wartezeit eingehalten wird, daß Fehler im Zeitverhalten eines Bildelements feststellbar sind.

## Claims

1. Method of particle beam testing in which a substrate for a liquid crystal display is tested,
which has a plurality of picture elements, wherein the substrate (SUBI) consists of a light-permeable insulator body, on the surface of which a plurality of surface electrodes (PE), control lines (L1, L2) and circuit elements with parasitic elements (R1, C1, R2, C2) are provided so that in each case a surface electrode is connected by way of at least one circuit element (T) to control lines (L1, L2),
wherein in each case within a setting time interval the control lines (L1, L2) are brought to a predetermined potential or a defined current is delivered to the surface electrode (PE) with the aid of a particle beam (S2),
and within a measurement time interval the potential which is set on the surface electrode (PE) is measured by determining the secondary electrons (S5) emitted by the particle beam (S3) and is compared with a particular desired potential and from this comparison a test result of a picture element is formed,
wherein between the end of the setting time interval and the beginning of the measurement time interval a waiting time is maintained which is defined in such a way that errors in the time behaviour of a picture element can be detected.

2. Method as claimed in Claim 1, characterised in that the control lines (L1, L2) which are connected to a surface electrode (PE) by way of a circuit element (T) are brought to a predetermined potential in each case by way of their line connections (A1, A2).

3. Method as claimed in Claim 1, characterised in that the control lines (L1, L2) which are connected to a surface electrode (PE) by way of a circuit element (T) are brought to a predetermined potential in each case by way of a particle beam (S1, S4).

4. Method of particle beam testing in which a substrate for a liquid crystal display is tested,
which has a plurality of picture elements, wherein the substrate (SUB1) consists of a light-permeable insulator body, on the surface of which a plurality of surface electrodes (PE), control lines (L1, L2) and circuit elements with parasitic elements (R1, C1, R2, C2) are provided so that in each case a surface electrode is connected by way of at least one circuit element (T) to control lines (L1, L2),
wherein in each case within a setting time interval a defined current (I) is delivered to the surface electrode (PE) with the aid of a particle beam (S2),
and within a measurement time interval a current (I1, 12) of a control line (L1, L2) which is connected by way of a circuit element (T) to a surface electrode (PE) is measured, wherein the current measurement takes place by way of a line connection (A1, A2) of the control line (L1, L2), and in which in each case the measured current (I1, I2) is compared with a particular desired current and from this comparison a test result for a picture element is formed,
wherein between the end of the setting time interval and the beginning of the measurement time interval a waiting time is maintained which is defined in such a way that errors in the time behaviour of a picture element can be detected.

## Revendications

1. Procédé de contrôle par faisceau corpusculaire, suivant lequel un substrat d'un affichage à cristaux liquides est contrôlé,
affichage qui possède de multiples éléments d'image, le substrat (SUB1) consistant en un corps isolant laissant passer la lumière et sur la surface duquel de multiples électrodes planes (PE), des conducteurs de commande (L1, L2) et des éléments de couplage comprenant des éléments parasites (R1, C1, R2, C2) sont déposés de manière que chaque électrode plane soit connectée par au moins un élément de commutation (T) à des conducteurs de commande (L1, L2),
procédé suivant lequel les conducteurs de commande (L1, L2) sont portés pendant un intervalle de temps de réglage à un potentiel prescrit ou un courant défini est dirigé sur l'électrode plane (PE) à l'aide d'un faisceau corpusculaire (S2)
et le potentiel qui s'établit aux bornes de l'électrode plane (PE) est mesuré pendant un intervalle de temps de mesure par la détermination des électrons secondaires (S5) libérés par un faisceau corpusculaire (S3) et il est comparé dans chaque cas à un potentiel de consigne et un résultat de contrôle d'un élément d'image en est formé,
un temps d'attente défini étant observé entre la fin de l'intervalle de temps de réglage et le début de l'intervalle de temps de mesure de façon telle que des défauts de la tenue dans le temps d'un élément d'image puissent être observés.

2. Procédé selon la revendication 1, caractérisé en ce que les conducteurs de commande (L1, L2), qui sont connectés par un élément de commutation (T) à une électrode plane (PE), sont portés à un potentiel prescrit particulier par leurs connexions propres (A1, A2).

3. Procédé selon la revendication 1, caractérisé en ce que les conducteurs de commande (L1, L2), qui sont connectés par un élément de commutation (T) à une électrode plane (PE), sont portés à un potentiel prescrit particulier par un faisceau corpusculaire (S1, S4).

4. Procédé de contrôle par faisceau corpusculaire, suivant lequel un substrat d'un affichage à cristaux liquides est contrôlé,
affichage qui possède de multiples éléments d'image, le substrat (SUB1) consistant en un corps isolant laissant passer la lumière et à la surface duquel de multiples électrodes planes (PE), des conducteurs de commande (L1, L2) et des éléments de couplage comprenant des éléments parasites (R1, C1, R2, C2) sont déposés de manière que chaque électrode plane soit connectée par au moins un élément de commutation (T) à des conducteurs de commande (L1, L2),
procédé suivant lequel un courant défini (I) est dirigé pendant un intervalle de temps de réglage sur l'électrode plane (PE) à l'aide d'un faisceau corpusculaire (S2)
et un courant (I1, I2) d'un conducteur de commande (L1, L2), qui est connecté par un élément de commutation (T) à une électrode plane (PE), est mesuré pendant un intervalle de temps de mesure, la mesure du courant s'effectuant par une connexion propre (A1, A2) du conducteur de commande (L1, L2), et suivant lequel dans chaque cas le courant mesuré (I1, I2) est comparé à un courant de consigne correspondant et un résultat de contrôle d'un élément d'image en est formé,
un temps d'attente étant observé entre la fin de l'intervalle de temps de réglage et le début de l'intervalle de temps de mesure de manière que des défauts de la tenue dans le temps d'un élément d'image puissent être observés.
